Europäisches Patentamt

European Patent Office

Office européen des brevets

(11) Publication number: **0 507 077 A2**

## EUROPEAN PATENT APPLICATION

(21) Application number: **92103257.9**

(22) Date of filing: **26.02.92**

(51) Int. Cl.5: **H01L 23/528**

(30) Priority: **27.03.91 JP 63474/91**

(43) Date of publication of application:
**07.10.92 Bulletin 92/41**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**
Applicant: **TOSHIBA MICRO-ELECTRONICS**
**CORPORATION**
**25-1, Ekimaehoncho**
**Kawasaki-ku Kawasaki-shi(JP)**

(72) Inventor: **Nagasawa, Hironori**
**362-1-417 Hazawacho, Kanagawa-ku**
**Yokohama-shi, Kanagawa-ken(JP)**
Inventor: **Nekozuka, Katsuyuki**
**1-21-10-501 Matsumicho, Kanagawa-ku**
**Yokohama-shi, Kanagawa-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Semiconductor integrated circuit with a plurality of gate electrodes.

(57) A semiconductor integrated circuit with a plurality of gate electrodes (65A, 65B) for implementing a prescribed operation according to first and second control signals consists of an operating region (62A, 62B) with a plurality of devices for implementing the prescribed operation, a plurality of gate electrodes (65A, 65B) positioned on the operating region for respectively applying the first and second control signals to a gate region of the operating region (62A, 62B), a first hard-wire (67A) connected to one group of gate electrodes (65A) and arranged on a side of the operating region (62A, 62B) for transmitting the first control signal to the one group of gate electrodes (65A), and a second hard-wire (67B) connected to the other group of gate electrodes (65B) and arranged on the side opposite the first hard-wire (67A) for transmitting the second control signal to the other group of gate electrodes (65B).

FIG. 7

## BACKGROUND OF THE INVENTION

### 1. Field of the invention

The present invention relates to a semiconductor integrated circuit in which a pair of metal-semiconductor field-effect transistors (MESFETs) with gate electrodes are utilized, and, in particular, to a semiconductor integrated circuit in which the layout of the pattern of hard-wires connected to the respective gate electrodes is improved.

### 2. Description of Background

Generally, both the structure of a metal-semiconductor field-effect transistor (MESFET) in which a gate region is formed by a Schottky contact and the manufacturing method for the MESFET are simple. Therefore, the MESFET can be easily manufactured to shorten the gate length thereof so that the operating speed is improved in an integrated circuit assembled by utilizing the MESFET. In particular, a high speed integrated circuit using GaAs can be obtained which is suitable for reducing the gate length to a very small dimension.

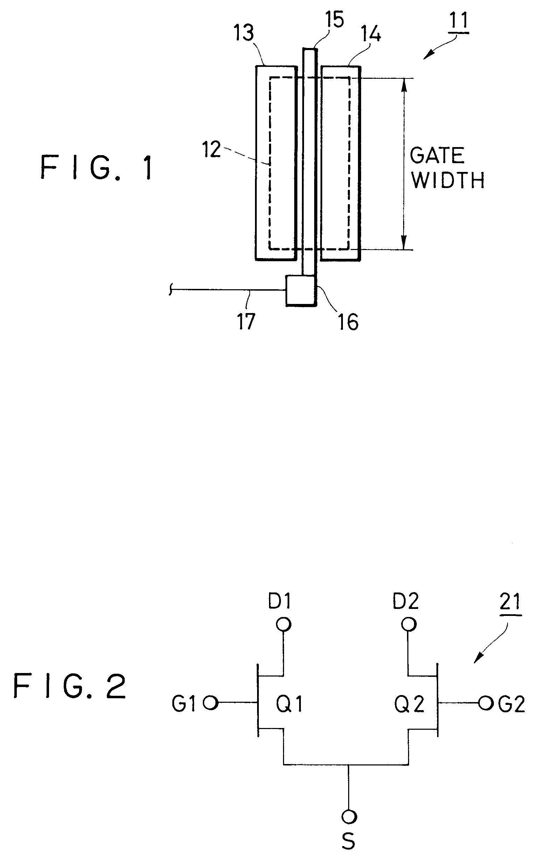

Fig. 1 is a plan view of a conventional MESFET.

As shown in Fig. 1, a conventional MESFET 11 comprises an operating region 12 for transferring a source charge such as electrons or electron holes from a source region to a drain region through a gate region according to a control signal transmitted to the gate region, a source electrode 13 disposed on the operating region 12 for applying the source charge to the source region, a drain electrode 14 disposed on the operating region 12 for receiving the source charge transferred from the source region to the drain region through the gate region, a gate electrode 15 disposed between the source electrode 13 and the drain electrode 14 on the operating region 12 for transmitting the control signal to the gate region, and a contact area 16 arranged on a side of the operating region 12 for connecting the gate electrode 15 to a gate hard-wire (word line) 17.

The conventional MESFET 11 with the above structure is utilized to make a differential amplifier.

Fig. 2 is a general circuit view of a differential amplifier in which a pair of MESFETs shown in Fig. 1 are utilized.

As shown in Fig. 2, a differential amplifier 21 comprises a pair of MESFETs Q1, Q2 shown in Fig. 1. That is, a symbol G1 (G2) indicates a gate terminal connected to the gate electrode 15 of the MESFET Q1 (Q2), a symbol D1 (D2) indicates a drain terminal connected to the drain electrode 14 of the MESFET Q1 (Q2), and a symbol S indicates a source terminal connected to the source electrode 13 of the MESFETs Q1 (Q2).

In the above configuration, each MESFET Q1 (Q2) is operated according to the control signal transmitted to each gate electrode G1 (G2).

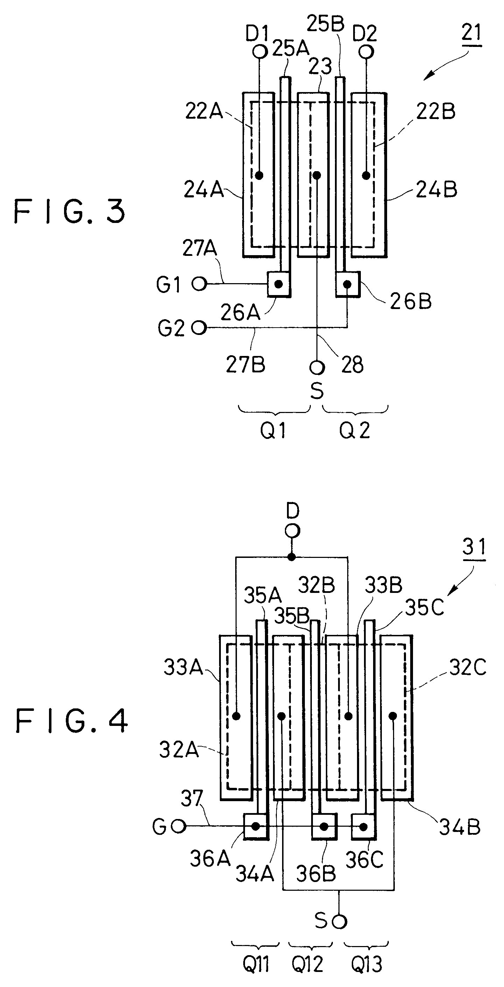

The electrodes in the differential amplifier 21 shown in Fig. 2 are arranged as shown in Fig. 3 in practice.

Fig. 3 is a plan view showing a conventional structure of the differential amplifier shown in Fig. 2 in which a pair of MESFETs shown in Fig. 1 are utilized.

As shown in Fig. 3, the differential amplifier 21 comprises:

an operating region 22A of the MESFET Q1 for transferring a source charge from a source region to a drain region through a gate region according to a control signal transmitted to the gate region;

an operating region 22B of the MESFET Q2 for transferring a source charge from a source region to a drain region through a gate region according to a control signal transmitted to the gate region, the source region of the MESFET Q2 being integrally formed with the source region of the MESFET Q1;

a source electrode 23 attached to both the MESFET Q1 source region and the MESFET Q2 source region and positioned on a boundary between the operating regions 22A, 22B for applying the source charge to the source regions of the operating regions 22A, 22B;

a drain electrode 24A of the MESFET Q1 disposed on one end of the operating region 22A for receiving the source charge transferred from the source region to the drain region through the gate region in the MESFET Q1;

a drain electrode 24B of the MESFET Q2 disposed on one end of the operating region 22B for receiving the source charge transferred from the source region to the drain region through the gate region in the MESFET Q2;

a gate electrode 25A of the MESFET Q1 disposed between the source electrode 23 and the drain electrode 24A on the operating region 22A for transmitting a first control signal to the gate region of the MESFET Q1;

a gate electrode 25B of the MESFET Q2 disposed between the source electrode 23 and the drain electrode 24B on the operating region 22B for transmitting a second control signal to the gate region of the MESFET Q2;

a contact area 26A disposed on a side of the operating regions 22A, 22B for connecting the gate electrode 25A with a first gate hard-wire 27A such as a word line, the first control signal being transmitted through the first gate hard-wire 27A; and

a contact area 26B disposed on the same side as the contact area 26A is disposed for connecting the gate electrode 25B with a second gate hard-wire 27B, the second control signal being transmitted through the second gate hard-wire 27B;

In the above structure of the differential amplifier 21, the first and second control signals are transmitted from the first and second gate hard-wires to the gate electrodes 25A, 25B of the MESFETs Q1, Q2 through the contact areas 26A, 26B. Moreover, the source charge is applied to the source electrode 23 through a source hard-wire (a bit line) 28 which is wired over or under the gate hard-wire.

In this case, dielectric substances are arranged between the first and second gate hard-wires 27A, 27B to avoid the generation of a short-circuit. The dielectric substances are arranged between the gate hard-wire 27A (27B) and the source hard-wire 28.

Therefore, a condenser is formed by the dielectric substances and the first and second gate hard-wires 27A, 27B when the control signals are transmitted through the gate hard-wires 27A, 27B because the gate hard-wires 27A, 27B are arranged side by side. In the same manner, a condenser is formed by the dielectric substances and the first or second gate hard-wire 27A (27B) because the source hard-wire 28 is wired over or under the gate hard-wire 27A (27B). As a result, parasitic capacitance is generated between the gate hard-wires 27A, 27B and between the gate hard-wire 27A (27B) and the source hard-wire 28.

Signals transmitted through the gate hard-wires are therefore delayed by the parasitic capacitance.

Accordingly, high speed processing with the differential amplifier is impossible.

Next, another conventional MESFET in which the driving performance is enhanced by enlarging the gate width is described with reference to Fig. 4.

Fig. 4 is a plan view showing a structure of three parallel-formed MESFETs.

As shown in Fig. 4, a parallel-formed MESFET 31 comprises sub-MESFETs Q11, Q12, and Q13 arranged in parallel in that order.

That is, each sub-MESFET Q11 (Q12, Q13) is provided with an operating region 32A (32B, 32C) for transferring a source charge from a source region to a drain region through a gate region according to a control signal transmitted to the gate region. The source region of the sub-MESFET Q12 is integrally formed with the source region of the sub-MESFET Q11, while the drain region of the sub-MESFET Q12 is integrally formed with the drain region of the sub-MESFET Q13.

Moreover, a drain electrode 33A is attached to the drain region of the sub-MESFET Q11, a source electrode 34A is attached to the source regions of the sub-MESFETs Q11, Q12, a drain electrode 33B is attached to the drain regions of the sub-MESFET Q12, Q13, and a source electrode 34B is attached to the source region of the sub-MESFET Q13.

Moreover, a gate electrode 35A of the sub-MESFET Q11 is disposed between the drain electrode 33A and the source electrode 34A, a gate electrode 35B of the sub-MESFET Q12 is disposed between the drain electrode 33B and the source electrode 34A, and a gate electrode 35C of the sub-MESFET Q13 is disposed between the drain electrode 33B and the source electrode 34B.

A contact area 36A is connected with the gate electrode 35A, a contact area 36B is connected with the gate electrode 35B, and a contact area 36C is connected with the gate electrode 35C. The contact areas 36A, 36B, and 36C are disposed on the same side of the operating regions 32A, 32B, and 32C and are connected with a gate hard-wire 37 such as a word line.

A source terminal S is arranged on the same side as the gate hard-wire 37, and a drain terminal D is arranged on the side opposite the source terminal S through the operating regions 32A, 32B, 32C.

In the above structure of the parallel-formed MESFET 31, the source charge applied to the source electrodes 34A, 34B is transferred in parallel to the drain electrodes 33A, 33B through the gates regions of the operating region 32A, 32B, 32C according to the control signal transmitted to the gate electrodes 35A, 35B, 35C.

Because the MESFET 31 is composed of three pieces of sub-MESFETs Q11, Q12, Q13 arranged in parallel, the gate width in practice is enlarged as compared with that of the MESFET 11 shown in Fig. 1, while each gate width of the sub-MESFETs is shorter than the gate width of the MESFET 11 shown in Fig. 1. Moreover, the gate resistance is reduced to a small value in the parallel-formed MESFET 31.

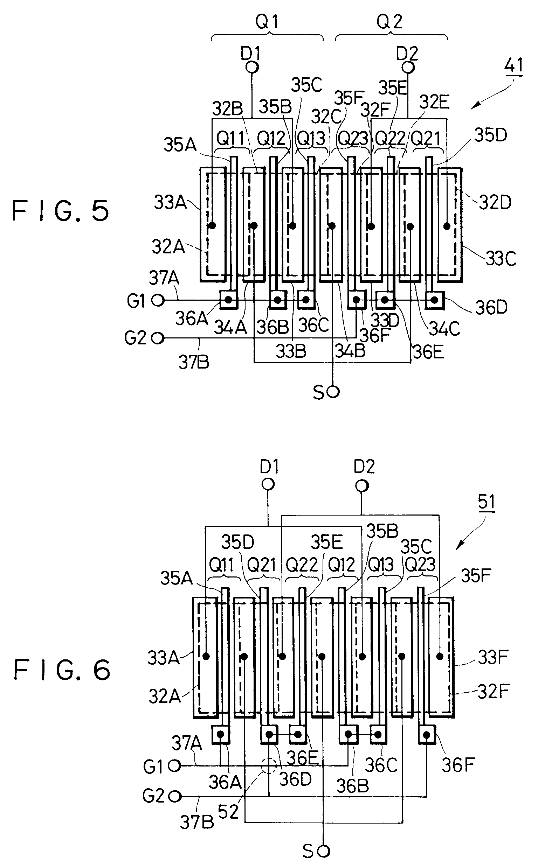

Fig. 5 is a plan view showing another conventional structure of the differential amplifier shown in Fig. 2 which is manufactured by utilizing a pair of parallel-formed MESFETs 31 shown in Fig. 4.

As shown in Fig. 5, a differential amplifier 41 comprises a pair of parallel-formed MESFETs Q1, Q2. Each MESFET Q1 (Q2) is shown in Fig. 4. That is, the differential amplifier 41 comprises sub-MESFETs Q11, Q12, Q13 of the MESFET Q1 and sub-MESFETs Q23, Q22, Q21 of the MESFET Q2 in that order. A source region of the sub-MESFET Q13 is integrally formed with a source region of the sub-MESFET Q23.

Moreover, the MESFET Q1 is provided with the drain electrodes 33A, 33B, the source electrodes 34A, 34B, and the gate electrodes 35A, 35B, 35C in the same manner as the MESFET 31 shown in Fig. 4.

In addition, the MESFET Q2 is provided with drain electrodes 33C, 33D, a source electrode 34C, and gate electrodes 35D, 35E, 35F. Each drain electrode 33C (33D) is attached to the drain region of the sub-MESFETs Q21, Q22 (Q22, Q23), the source electrode 34C is attached to the source region of the sub-MESFETs Q21, Q22, and each gate electrode 35D (35E, 35F) is disposed between the drain electrode 33C (33D) and the source electrode 34C (34C, 34D).

Moreover, a contact area 36D (36E, 36F) is provided to connect the gate electrode 35D (35E, 35F) to a second gate-wire 37B in addition to the contact areas 36A, 36B, 36C connected to a first gate-wire 37A. The contact areas 36D, 36E, 36F are arranged on the side on which the contact areas 36A, 36B, 36C are arranged.

In the above structure of the differential amplifier 41, six sub-MESFETs are arranged in parallel so that the distance between the two ends of the sub-MESFETs is 3 times as large as the distance in the differential amplifier 21 shown in Fig. 3. Usually, the pitch of the sub-MESFETs is about 6 $\mu$m. Therefore, in cases where more than ten sub-MESFETs are arranged in parallel in practice, the distance between the two ends of the sub-MESFETs is more than 60 $\mu$m.

In this case, the device characteristics, such as the electrical resistivity at one end of the sub-MESFET Q11 considerably differ from those of the other end of the sub-MESFET Q21. The reason is that many types of impurities are added to a semiconductor device and the device is heated and cooled when a semiconductor circuit is manufactured. Therefore, the device characteristics in a certain region are gradually shifted as the distance from the region increases.

Therefore, when the differential operation is implemented in each MESFET Q1 (Q2), many drawbacks such as the shift of offset characteristics resulting from the unevenness of the device characteristics between the MESFETs Q1, Q2 occurs. As a result, the characteristics of the semiconductor circuit deteriorate.

Moreover, a parasitic capacitance is generated between the gate hard-wires 37A, 37B and between the gate hard-wire 37A (37B) and the source hard-wire when control signals are transmitted through the gate hard-wires in the same manner as in the MESFET shown in Fig. 3. Therefore, signals transmitted through the word lines or the bit line are delayed by the parasitic capacitance.

Next, another conventional differential amplifier in which unevenness in the device characteristics are prevented is described with reference to Fig. 6.

Fig. 6 is a plan view of another conventional structure of the differential amplifier shown in Fig. 2 in which a pair of sub-MESFETs of the MESFET Q1 and a pair of sub-MESFETs of the MESFET Q2 are alternately arranged in parallel except for two ends of the parallel-formed sub-MESFETs.

As shown in Fig. 6, a conventional differential amplifier 51 comprises a pair of the parallel-formed MESFETs Q1, Q2 shown in Fig. 4. The MESFET Q1 comprises three sub-MESFETs Q11, Q12, and Q13. The MESFET Q2 comprises three sub-MESFETs Q21, Q22, and Q23. The sub-MESFETs Q11, Q21, Q22, Q12, Q13, Q23 are arranged in that order so that a pair of sub-MESFETs of the MESFET Q1 and a pair of sub-MESFETs of the MESFET Q2 are alternately arranged in parallel except for two ends of the parallel-formed sub-MESFETs.

Moreover, the contact areas 36A of the MESFET Q1 are arranged on the same side of the conventional differential amplifier 51 as the contact areas 36B of the MESFET Q2 are arranged.

In cases where each MESFET Q1 (Q2) is provided with a large number of sub-MESFETs, a pair of sub-MESFETs of the MESFET Q2 and a pair of sub-MESFETs of the MESFET Q1 are alternately arranged in parallel except for two ends of the parallel-formed sub-MESFETs. That is, the first sub-MESFET belongs to the MESFET Q1, and the second and third sub-MESFETs belong to the MESFET Q2. And, the last sub-MESFET belongs to the MESFET Q2, and the last sub-MESFET but one and the last sub-MESFET but two belong to the MESFET Q1.

Therefore, the device characteristics of the MESFET Q1 are substantially the same as those of the MESFET Q2.

Accordingly, the drawbacks resulting from the unevenness of the device characteristics between the MESFETs Q1, Q2 can be prevented.

However, the drawbacks resulting from the parasitic capacitance remain because both the first gate hard-wire 37A for transferring control signals to the gate electrodes 35A and the second gate hard-wire 37B for transferring control signals to the gate electrodes 35B are still arranged side by side.

Moreover, both the gate hard-wire are necessarily crossed at a point 52 in a crossing arrangement with an overpass or underpass because both a pair of sub-MESFETs of the MESFETs Q1 and a pair of sub-MESFETs of the MESFETs Q2 are alternately arranged. Moreover, the distance between the hard-wires 37A, 37B is shortened.

Therefore, the drawbacks resulting from the parasitic capacitance are newly generated at the crossing point 52 and between the hard-wires 37A, 37B.

The extent of the drawbacks increases remarkably as the number of sub-MESFETs is increased.

Moreover, the above drawbacks resulting from the parasitic capacitance are not limited to the differential amplifier. That is, the drawbacks occur in any type of semiconductor integrated circuit with a plurality of gate electrodes in which the hard-wires respectively connected with the gate electrode are arranged side by side or are crossed in a crossing arrangement with an overpass or underpass.

## SUMMARY OF THE INVENTION

An object of the present invention is to provide, with due consideration to the drawbacks of such conventional circuit, a semiconductor integrated circuit with a plurality of gate electrodes in which the parasitic capacitance generated between gate hard-wires respectively connected with the gate electrode is lowered and the device characteristics of semiconductor devices utilized to manufacture the semiconductor integrated circuit are uniformly set.

The above object is achieved by the provision of a semiconductor integrated circuit with a plurality of gate electrodes (65A, 65B) for implementing a prescribed operation according to first and second control signals, comprising:

an operating region (62A, 62B) with a plurality of devices for implementing the prescribed operation, a source charge being transferred from a source region to a drain region through a gate region according to the control signal in each device;

a plurality of gate electrodes (65A, 65B) positioned on the operating region (62A, 62B) for respectively applying the first and second control signals to the gate region of the operating region (62A, 62B);

a first hard-wire (67A) connected to one group of gate electrodes (65A) and arranged on a side of the operating region (62A, 62B) for transmitting the first control signal to the one group of gate electrodes (65A); and

a second hard-wire (67B) connected to the other group of gate electrodes (65B) and arranged on the side opposite the first hard-wire (67A) for transmitting the second control signal to the other group of gate electrodes (66B), the second hard-wire (67B) being arranged at some distance from the first hard-wire (67A).

In the above structure of the semiconductor integrated circuit, the second hard-wire is arranged on the side opposite the first hard-wire. In other words, the operating region is arranged between the first and second hard-wires.

Therefore, the two hard-wires are not crossed in a crossing arrangement with an overpass or underpass. Moreover, the second hard-wire is positioned at some distance from the first hard-wire.

Accordingly, the parasitic capacitance is not generated between the first and second hard-wires.

Moreover, the above object is achieved by the provision of a semiconductor integrated circuit with a plurality of gate electrodes (65A, 65B) for implementing a prescribed operation according to first and second control signals, comprising:

an operating region (62A, 62B) of a differential amplifier (61) composed of a pair of metal-semiconductor field-effect transistors (Q1, Q2) for implementing the prescribed operation, a source charge being transferred from a source region to a drain region through a gate region according to the first or second control signal in each metal-semiconductor field-effect transistor (Q1, Q2) and the source regions of the two transistors (Q1, Q2) being integrally formed;

a pair of gate electrodes (65A, 65B) positioned on the operating region (62A, 62B) for respectively applying the first or second control signal to the gate region of the transistor (Q1, Q2);

a first hard-wire (67A) connected to one gate electrode (65A) and arranged on a side of the operating region (62A, 62B) for transmitting the first control signal to the one gate electrode of one transistor (Q1); and

a second hard-wire (67B) connected to another gate electrode (65B) and arranged on the side opposite the first hard-wire (67A) for transmitting the second control signal to another gate electrode of another transistor (Q2), the second hard-wire (67B) being arranged at some distance from the first hard-wire(67A).

In the above structure of the semiconductor integrated circuit, the second hard-wire is arranged on the side opposite the first hard-wire. In other words, the operating region of the differential amplifier is arranged between the first and second hard-wires.

Therefore, the two hard-wires are not crossed in a crossing arrangement with an overpass or underpass. Moreover, the second hard-wire is positioned at some distance from the first hard-wire.

Accordingly, the amplification can be rapidly implemented in the differential amplifier because the parasitic capacitance is not generated between the first and second hard-wires.

Moreover, the above object is achieved by the provision of a semiconductor integrated circuit with a plurality of gate electrodes (74A to 74F) for implementing a prescribed operation according to first and second control signals, comprising:

an operating region (32A to 32F) of a differential amplifier (71) composed of a first and a second metal-semiconductor field-effect transistor (Q1, Q2) respectively formed from a large number of sub-transistors (Q11, Q12, Q13, Q21, Q22, Q23) for implementing the prescribed operation,

(1) a pair of sub-transistors(Q12, Q13) of the first transistor (Q1) and a pair of the sub-transistors (Q21, Q22) of the second transistor (Q2) being alternately arranged in parallel, and

(2) a source charge being transferred from a source region to a drain region through a gate region according to the first or second control signal in each sub-transistor (Q11, Q12, Q13, Q21, Q22, Q23);

a large number of gate electrodes (74A to 74F) respectively attached to one gate region of the sub-transistor (Q11, Q12, Q13, Q21, Q22, Q23) and positioned on the operating region (32A to 32F) for respectively applying the first or second control signal to the gate region of the sub-transistor (Q11, Q12, Q13, Q21, Q22, Q23);

a first hard-wire (76) connected to one group of gate electrodes (74A, 74B, 74C) attached to the gate regions of the sub-transistors (Q11, Q12, Q13) of the first transistor (Q1) and arranged on a side of the operating region (32A to 32F) for transmitting the first control signal to the gate electrodes (74A, 74B, 74C) of the sub-transistors (Q11, Q12, Q13) of the first transistor (Q1);

a second hard-wire (77) connected to another group of gate electrodes (74D, 74E, 74F) attached to the gate regions of the sub-transistors (Q21, Q22, Q23) of the second transistor (Q2) and arranged on the side opposite the first hard-wire (76) for transmitting the second control signal to the gate electrodes (74D, 74E, 74F) of the sub-transistors (Q21, Q22, Q23) of the second transistor (Q2), the second hard-wire (77) being arranged at some distance from the first hard-wire (76);

a large number of drain electrodes (73A to 73D) respectively attached to one drain region of the sub-transistor (Q11, Q12, Q13, Q21, Q22, Q23) and positioned on the operating region (32A to 32F) for respectively receiving the source charge from the drain region, the drain electrodes (73A, 73C) attached to the drain regions of the sub-transistors (Q11, Q12, Q13) of the first transistor (Q1) being connected each other and the other drain electrodes (73B, 73D) attached to the drain regions of the sub-transistors (Q21, Q22, Q23) of the second transistor (Q2) being connected each other; and

a large number of source electrodes (72A to 72C) respectively attached to one source region of the sub-transistor (Q11, Q12, Q13, Q21, Q22, Q23) and positioned on the operating region (32A to 32F) for respectively receiving the source charge from the source region, the source electrodes (72A to 72C) being connected each other.

In the above structure of the semiconductor integrated circuit, the second hard-wire is arranged on the side opposite the first hard-wire. In other words, the operating region is arranged between the first and second hard-wires.

Therefore, the two hard-wires are not crossed in a crossing arrangement with an overpass or underpass. Moreover, the second hard-wire is positioned far from the first hard-wire.

Accordingly, the amplification can be rapidly implemented in the differential amplifier because the parasitic capacitance is not generated between the first and second hard-wires.

Moreover, because a pair of sub-transistors of the first transistor and a pair of sub-transistors of the second transistor are alternately arranged in parallel, the device characteristics of the first transistor are the same as those of the second transistors.

Accordingly, when a gate electrode of each transistor is provided with a control signal, the first and second transistors can be operated in the same manner. That is, the differential amplifier can be accurately operated.

## BRIEF DESCRIPTION OF THE DRAWINGS

Fig. 1 is a plan view of a conventional MESFET.

Fig. 2 is a general circuit view of a differential amplifier in which a pair of MESFETs shown in Fig. 1 are utilized.

Fig. 3 is a plan view showing a conventional structure of the differential amplifier shown in Fig. 2 in which a pair of MESFETs shown in Fig. 1 are utilized.

Fig. 4 is a plan view showing a structure of three parallel-formed MESFETs.

Fig. 5 is a plan view showing another conventional structure of the differential amplifier shown in Fig. 2 which is manufactured by utilizing a pair of MESFETs 31 shown in Fig. 4.

Fig. 6 is a plan view of another conventional structure of the differential amplifier shown in Fig. 2 in which a pair of sub-MESFETs of a MESFET Q1 and a pair of sub-MESFETs of a MESFET Q2 are alternately arranged in parallel.

Fig. 7 is a plan view showing a structure of a semiconductor integrated circuit with a plurality of gate electrodes according to a first embodiment of the present invention.

Fig. 8 is a plan view of another structure of the differential amplifier shown in Fig. 2 in which a pair of sub-MESFETs of a MESFET Q1 and a pair of sub-MESFETs of a MESFET Q2 are alternately arranged in parallel.

## DETAILED DESCRIPTION OF THE PREFERRED EMBODIMENTS

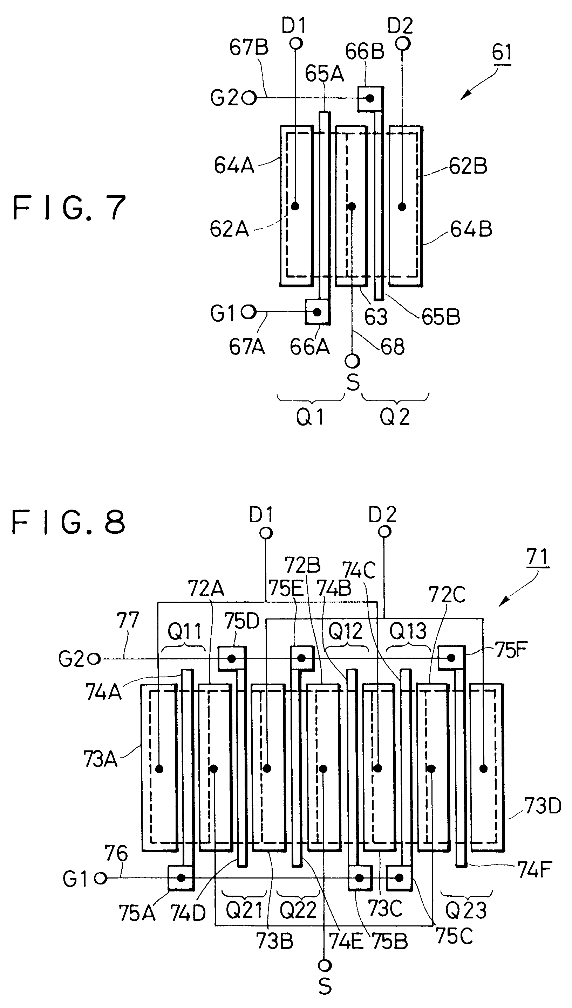

Preferred embodiments of a semiconductor integrated circuit with a plurality of gate electrodes are described with reference to Figs. 7, 8.

Fig. 7 is a plan view showing a structure of a semiconductor integrated circuit with a plurality of gate electrodes according to a first embodiment of the present invention.

The semiconductor integrated circuit shown in Fig. 7 is the differential amplifier shown in Fig. 2.

As shown in Fig. 7, a differential amplifier 61 comprises:

an operating region 62A of a MESFET Q1 for transferring a source charge from a source region to a drain region through a gate region according to a control signal transmitted to the gate region;

an operating region 62B of a MESFET Q2 for transferring a source charge from a source region to a drain region through a gate region according to a control signal transmitted to the gate region, a source region of the MESFET Q2 being integrally formed with the source region of the MESFET Q1;

a source electrode 63 integrally formed with both the MESFET Q1 source region and the MESFET Q2 source region and positioned on the boundary between the operating regions 22A, 22B for applying the source charge to the source region of each operating region 22A (22B);

a drain electrode 64A of the MESFET Q1 disposed on an end of the operating region 62A for receiving the source charge transferred from the MESFET Q1 source region to the MESFET Q1 drain region through the MESFET Q1 gate region;

a drain electrode 64B of MESFET Q2 disposed on an end of the operating region 62B for receiving the source charge transferred from the MESFET Q2 source region to the MESFET Q2 drain region through the MESFET Q2 gate region;

a gate electrode 65A of the MESFET Q1 disposed between the source electrode 63 and the MESFET Q1 drain electrode 64A on the operating region 62A for applying the control signal to the MESFET Q1 gate region;

a gate electrode 65B of the MESFET Q2 disposed between the source electrode 63 and the MESFET Q2 drain electrode 64B on the operating region 62B for applying the control signal to the MESFET Q2 gate region,

a contact area 66A positioned apart from the operating regions 62A, 62B and arranged on a side of the operating regions 62A, 62B for connecting the gate electrode 65A to a first gate hard-wire 67A such as a first word line, and

a contact area 66B disposed apart from the operating regions 62A, 62B and arranged on the side opposite the contact area 66A for connecting the gate electrode 65B to a second gate hard-wire 67B such as a second word line.

In the above structure of the differential amplifier 61, a first control signal is transmitted from the first gate hard-wire 67A to the gate electrode 65A of the MESFET Q1 through the contact area 26A to control the operation implemented in the operating region 62A. In the same manner, a second control signal is transmitted from the second gate hard-wire 67B to the gate electrode 65B of the MESFET Q2 through the contact area 26B to control the operation implemented in the operating region 62B.

The source charge is applied to the source electrode 23 through a source hard-wire (a bit line) 68.

In this case, because the first hard-wire 67A is arranged on one side of the operating regions 62A, 62B and the second hard-wire 67B is arranged on the other side of the operating regions 62A, 62B, the first hard-wire 67A is arranged at some distance from the second hard-wire 67B through the operating regions 62A, 62B and dielectric substances.

Therefore, no electromagnetic interaction between the first and second hard-wires is generated by the first and second control signals. In other words, no parasitic capacitance is generated between the gate hard-wires.

The source hard wire 68 is not wired in a crossing arrangement with an overpass or underpass. Therefore, no parasitic capacitance is generated between the gate hard-wire and the source hard-wire regardless of whether the source charge and the control signal are transmitted through the hard-wires.

Accordingly, control signals transmitted through the first and second hard-wires are not delayed by a parasitic capacitance so that high speed processing in the differential amplifier 61 is possible.

Next, a second embodiment is described with reference to Fig. 8.

Fig. 8 is a plan view of another structure of the differential amplifier shown in Fig. 2 in which the sub-MESFETs of one MESFET Q1 (Q2) are replaced with the sub-MESFETs of the other MESFET Q2 (Q1) every two sub-MESFETs in a parallel arrangement of the sub-MESFETs.

As shown in Fig. 8, a differential amplifier 71 comprises a pair of the parallel-formed MESFETs Q1, Q2 shown in Fig. 4.

The MESFET Q1 comprises three sub-MESFETs Q11, Q12, and Q13. The MESFET Q2 comprises three sub-MESFETs Q21, Q22, and Q23. A source charge is transferred from a source region to a drain region through a gate region according to a control signal transmitted to the gate region in each sub-MESFET. The sub-MESFETs Q11, Q21, Q22, Q12, Q13, Q23 are arranged in that order.

The source regions or drain regions of the sub-MESFETs arranged side by side are integrally formed. That is, the source regions of the sub-MESFETs Q11, Q21 are integrally formed so that a source electrode 72A is attached to the source regions. The source regions of the sub-MESFETs Q22, Q12 are integrally formed so that a source electrode 72B is attached to the source regions. The source regions of the sub-MESFETs Q13, Q23 are integrally formed so that a source electrode 72C is attached to the source regions.

Moreover, a drain electrode 73A attached to the drain region of the sub-MESFET Q11 is arranged on one side of the parallel-formed MESFETs Q1, Q2. The drain regions of the sub-MESFETs Q21, Q22 are integrally formed so that a drain electrode 73B is attached to the drain regions of the sub-MESFETs Q21, Q22. The drain regions of the sub-MESFETs Q12, Q13 are integrally formed so that a drain electrode 73C is attached to the drain regions. A drain electrode 73D attached to the drain region of the sub-MESFET Q23 is arranged on the other side of the parallel-formed MESFETs Q1, Q2.

Each gate electrode 74A (74B, 74C) of the sub-MESFET Q11 (Q12, Q13) is connected to a corresponding contact area 75A (75B, 75C) which is arranged on a side of the sub-MESFETs. The contact area 75A (75B, 75C) is connected to a first gate hard-wire 76 to transmit a first control signal to the gate regions of the sub-MESFETs Q11, Q12, and Q13 of the MESFET Q1. In the same manner, each gate electrode 74D (74E, 74F) of the sub-MESFET Q21 (Q22, Q23) is connected to a corresponding contact area 75D (75E, 75F) which is arranged on the side opposite the contact area 75A (75B, 75C) and is separated from the sub-MESFETs. The contact area 75D (75E, 75F) is connected to a second gate hard-wire 77 to transmit a second control signal to the gate regions of the sub-MESFETs Q21, Q22, and Q23 of the MESFET Q2.

Generally, in cases where the MESFETs Q1, Q2 respectively comprise a large number of sub-MESFETs arranged in parallel, a sub-MESFET of the MESFET Q1 is initially arranged on one end of a series of sub-MESFETs and a pair of sub-MESFETs of the MESFET Q2 and a pair of sub-MESFETs of the MESFET Q1 are alternately arranged in succession in parallel. Finally, a sub-MESFET of the MESFET Q2 is arranged on the other end of a series of sub-MESFETs.

In the above structure of the differential amplifier 71, the contact areas 75A, 75B, 75C connected to the first gate hard-wire 76 are arranged on a side of the sub-MESFETs and the contact areas 75D, 75E, 75F connected to the second gate hard-wire 77 are arranged on the side opposite the contact areas 75A, 75B, 75C. In other words, the first gate hard-wire 76 is disposed at a considerable distance from the second gate hard-wire 77 through the sub-MESFETs.

Therefore, when the differential amplifier 71 is operated by receiving the first and second control signals at the gate regions of the sub-MESFETs of the MESFETs Q1, Q2, no electromagnetic interaction between the first and second hard-wires is generated by the first and second electric signals. In other words, no parasitic capacitance is generated between the gate hard-wires.

Accordingly, electric signals transmitted through the first and second hard-wires are not delayed by parasitic capacitance so that high speed processing in the differential amplifier 71 is possible.

Moreover, because the sub-MESFETs are arranged in parallel by alternately arranging a pair of sub-MESFETs of the MESFET Q1 and a pair of sub-MESFETs of the MESFET Q2, the device characteristics of the MESFET Q1 are substantially the same as that of the MESFET Q2.

Accordingly, a precise operation can be implemented in the differential amplifier 71.

Having illustrated and described the principles of our invention in a preferred embodiment thereof, it should be readily apparent to those skilled in the art that the invention can be modified in arrangement and detail without departing from such principles. We claim all modifications coming within the spirit and scope of the accompanying claims.

Reference signs in the claims are intended for better understanding and shall not limit the scope.

## Claims

1.  A semiconductor integrated circuit with a plurality of gate electrodes (65A, 65B) for implementing a prescribed operation according to first and second control signals, comprising:

    an operating region (62A, 62B) with a plurality of devices for implementing the prescribed operation, a source charge being transferred from a source region to a drain region through a gate region according to the control signal in each device;

    a plurality of gate electrodes (65A, 65B) positioned on the operating region (62A, 62B) for respectively applying the first and second control signals to the gate region of the operating region (62A, 62B);

    a first hard-wire (67A) connected to one group of gate electrodes (65A) and arranged on a side of the operating region (62A, 62B) for transmitting the first control signal to the one group of gate electrodes (65A); and

    a second hard-wire (67B) connected to the other group of gate electrodes (65B) and arranged on the side opposite the first hard-wire (67A) for transmitting the second control signal to the other group of gate electrodes (66B), the second hard-wire (67B) being arranged at some distance from the first hard-wire (67A).

2. A semiconductor integrated circuit with a plurality of gate electrodes (65A, 65B) for implementing a prescribed operation according to first and second control signals, comprising:

an operating region (62A, 62B) of a differential amplifier (61) composed of a pair of metal-semiconductor field-effect transistors (Q1, Q2) for implementing the prescribed operation, a source charge being transferred from a source region to a drain region through a gate region according to the first or second control signal in each metal-semiconductor field-effect transistor (Q1, Q2) and the source regions of the two transistors (Q1, Q2) being integrally formed;

a pair of gate electrodes (65A, 65B) positioned on the operating region (62A, 62B) for respectively applying the first or second control signal to the gate region of the transistor (Q1, Q2);

a first hard-wire (67A) connected to one gate electrode (65A) and arranged on a side of the operating region (62A, 62B) for transmitting the first control signal to the one gate electrode of one transistor (Q1); and

a second hard-wire (67B) connected to another gate electrode (65B) and arranged on the side opposite the first hard-wire (67A) for transmitting the second control signal to another gate electrode of another transistor (Q2), the second hard-wire (67B) being arranged at some distance from the first hard-wire(67A).

3. A semiconductor integrated circuit with a plurality of gate electrodes (74A to 74F) for implementing a prescribed operation according to first and second control signals, comprising:

an operating region (32A to 32F) of a differential amplifier (71) composed of a first and a second metal-semiconductor field-effect transistor (Q1, Q2) respectively formed from a large number of sub-transistors (Q11, Q12, Q13, Q21, Q22, Q23) for implementing the prescribed operation,

(1) a pair of sub-transistors(Q12, Q13) of the first transistor (Q1) and a pair of the sub-transistors (Q21, Q22) of the second transistor (Q2) being alternately arranged in parallel, and

(2) a source charge being transferred from a source region to a drain region through a gate region according to the first or second control signal in each sub-transistor (Q11, Q12, Q13, Q21, Q22, Q23);

a large number of gate electrodes (74A to 74F) respectively attached to one gate region of the sub-transistor (Q11, Q12, Q13, Q21, Q22, Q23) and positioned on the operating region (32A to 32F) for respectively applying the first or second control signal to the gate region of the sub-transistor (Q11, Q12, Q13, Q21, Q22, Q23);

a first hard-wire (76) connected to one group of gate electrodes (74A, 74B, 74C) attached to the gate regions of the sub-transistors (Q11, Q12, Q13) of the first transistor (Q1) and arranged on a side of the operating region (32A to 32F) for transmitting the first control signal to the gate electrodes (74A, 74B, 74C) of the sub-transistors (Q11, Q12, Q13) of the first transistor (Q1);

a second hard-wire (77) connected to another group of gate electrodes (74D, 74E, 74F) attached to the gate regions of the sub-transistors (Q21, Q22, Q23) of the second transistor (Q2) and arranged on the side opposite the first hard-wire (76) for transmitting the second control signal to the gate electrodes (74D, 74E, 74F) of the sub-transistors (Q21, Q22, Q23) of the second transistor (Q2), the second hard-wire (77) being arranged at some distance from the first hard-wire (76);

a large number of drain electrodes (73A to 73D) respectively attached to one drain region of the sub-transistor (Q11, Q12, Q13, Q21, Q22, Q23) and positioned on the operating region (32A to 32F) for respectively receiving the source charge from the drain region, the drain electrodes (73A, 73C) attached to the drain regions of the sub-transistors (Q11, Q12, Q13) of the first transistor (Q1) being connected each other and the other drain electrodes (73B, 73D) attached to the drain regions of the sub-transistors (Q21, Q22, Q23) of the second transistor (Q2) being connected each other; and

a large number of source electrodes (72A to 72C) respectively attached to one source region of the sub-transistor (Q11, Q12, Q13, Q21, Q22, Q23) and positioned on the operating region (32A to 32F) for respectively receiving the source charge from the source region, the source electrodes (72A to 72C) being connected each other.

FIG. 1

13  15  14  11

12

GATE WIDTH

17  16

FIG. 2

D1        D2        21

G1 ⃝  Q1      Q2  ⃝ G2

S

FIG.3

D1  25A  25B  D2  21
22A  23  22B
24A  24B
27A
G1  26A  26B
G2  27B  28
S
Q1  Q2

FIG.4

D  31
35A  32B  33B  35C
35B
33A  32C
32A
37  34B
G  34A  36C
36A  36B
S
Q11  Q12  Q13

FIG.5

FIG.6

F I G. 7

F I G. 8